(19) Europäisches Patentamt / European Patent Office / Office européen des brevets

(11) **EP 2 461 354 A1**

(12) **EUROPEAN PATENT APPLICATION**
published in accordance with Art. 153(4) EPC

(43) Date of publication:
**06.06.2012 Bulletin 2012/23**

(21) Application number: **10804125.2**

(22) Date of filing: **29.07.2010**

(51) Int Cl.:
$H01L\ 21/336^{(2006.01)}$    $C23C\ 14/06^{(2006.01)}$
$H01L\ 21/28^{(2006.01)}$    $H01L\ 21/285^{(2006.01)}$
$H01L\ 29/423^{(2006.01)}$    $H01L\ 29/49^{(2006.01)}$
$H01L\ 29/78^{(2006.01)}$

(86) International application number:
**PCT/JP2010/004803**

(87) International publication number:
**WO 2011/013374 (03.02.2011 Gazette 2011/05)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **29.07.2009 JP 2009176177**

(71) Applicant: **Canon Anelva Corporation
Kawasaki-shi
Kanagawa 215-8550 (JP)**

(72) Inventors:
• **NAKAGAWA, Takashi
Kawasaki-shi
Kanagawa 215-8550 (JP)**

• **KITANO, Naomu
Kawasaki-shi
Kanagawa 215-8550 (JP)**
• **MATSUO, Kazuaki
Kawasaki-shi
Kanagawa 215-8550 (JP)**
• **KOSUDA, Motomu
Kawasaki-shi
Kanagawa 215-8550 (JP)**
• **TATSUMI, Toru
Kawasaki-shi
Kanagawa 215-8550 (JP)**

(74) Representative: **TBK
Bavariaring 4-6
80336 München (DE)**

(54) **SEMICONDUCTOR DEVICE AND MANUFACTURING METHOD THEREFOR**

(57) A gate electrode achieves a desired work function in a semiconductor device including a field-effect transistor equipped with a gate electrode composed of a metal nitride layer.

The semiconductor device includes a silicon substrate and a field-effect transistor provided on the silicon substrate and having a gate insulating film and a gate electrode provided on the gate insulating film. The gate insulating film includes a high-permittivity insulating film formed of a metal oxide, a metal silicate, a metal oxide introduced with nitrogen, or a metal silicate introduced with nitrogen, and the gate electrode includes at least a metal nitride layer containing Ti and N. At least a part which is in contact with the gate insulating film of the metal nitride layer has a molar ratio between Ti and N (N/Ti ratio) of not less than 1.15 and a film density of not less than 4.7 g/cc.

[Fig. 1]

## Description

Technical Field

This invention relates to a semiconductor device, which has a high-permittivity insulating film and a metal gate electrode, a method of manufacturing the semiconductor device, and a manufacturing program, and relates particularly to a technique for improving the performance of an MOSFET (Metal Oxide Semiconductor Field Effect Transistor).

Background Art

In advanced CMOS (complementary MOS) device development realized miniaturization of a transistor, deterioration of a drive current due to depletion of a polysilicon (poly-Si) electrode and increase in gate current due to thinning of a gate insulating film become problems. Thus, there has been studied a complex technology for preventing the depletion of the electrode by the application of a metal gate, and, at the same time, increasing a physical film thickness by using a high permittivity material in a gate insulating film to thereby reduce gate leak current. For example, a pure metal, a metal nitride, or a silicide material has been considered as a material used in a metal gate electrode. However, in any case, a threshold value voltage (Vth) of an N-type MOSFET (MOS field-effect transistor) and a P-type MOSFET must be able to be set to an appropriate value. When a conventional gate electrode with interposition of a polycrystalline silicon layer is used, the threshold value voltage of a transistor is determined by an impurity concentration of a channel region and an impurity concentration in the polycrystalline silicon film. Meanwhile, when a metal gate electrode is used, the threshold value voltage of the transistor is determined by the impurity concentration of the channel region and a work function of a gate electrode. To realize a threshold voltage (Vth) of a CMOS transistor (a gate voltage at which drain current stops flowing in a CMOS transistor) of not more than $\pm 0.5V$, for the N-type MOSFET, a material with a work function of not more than the mid-gap of Si (4.6 eV), preferably not more than 4.4 eV is required to be used in the gate electrode, and for the P-type MOSFET, a material with a work function of not less than the mid-gap of Si (4.6 eV), preferably not less than 4.8 eV is required to be used in the gate electrode.

As one of means for achieving such gate electrodes, the use of titanium nitride (TiN) as a metal gate electrode material has been researched.

For example, Patent Document 1 discloses, as a method of changing the work function of TiN, a technique for changing the work function by a nitrogen concentration of titanium nitride, using a gate electrode having a stacked structure of high-melting-point metals such as TiN and tungsten. The Patent Document 1 discloses that according to this method, the work function can be reduced by the increase of the flow ratio of nitrogen gas in the formation of TiN by ion implantation of nitrogen into a TiN film and reactive sputtering and by the increase of the percentage of nitrogen contained in the TiN film. The Patent Document 1 further discloses that the nitrogen content percentage in the reactive sputtering is 100%, so that the crystalline orientation of the TiN film is changed to (200) substantially, whereby TiN with a low work function suitable for a gate electrode of an N-type channel MOSFET can be obtained.

Patent Document 2 discloses an apparatus for manufacturing a semiconductor device, which is capable of suppressing variations in the work function of a gate electrode by aligning the plane directions of a metal gate electrode of a portion in contact with a gate insulating film so that variations in the threshold of a transistor are reduced. The Patent Document 2 discloses that the work function of TiN is changed by the surface orientation (crystalline orientation of a surface) of TiN, and the work function is 4.3 eV in the (100) orientation (crystalline orientation) and is 4. 6 eV in the (111) orientation (crystalline orientation).

Patent Document 3 discloses a method using a gate electrode having a stacked structure of polycrystalline silicon, PVD-TiN (second metal layer), and CVD-TiN (first metal layer). The Patent Document 3 discloses that according to this method, TiN which is the first metal layer is formed at a low temperature of not more than 450°C by a thermal CVD method using $TiCl_4$ and $NH_3$, whereby gate leak current can be reduced by suppressing damage to a gate insulating film, and TiN suitable for a metal gate of the P-type MOSFET and having a work function of 4.8 eV can be realized. The Patent Document 3 further discloses that TiN which is the second metal layer is formed at 500°C (higher than the temperature when TiN as the first metal layer is formed) by a PVD method, whereby TiN oriented in a (100) plane is formed. The Patent Document 1 further discloses that a gate electrode in which diffusion of silicon from polycrystalline silicon is suppressed by the PVD-TiN (second metal layer) can be obtained.

Patent Document 4 discloses that the device characteristics of a semiconductor device comprising a gate electrode having a stacked structure of TiN and tungsten and a high-permittivity gate insulating film (hafnium nitride silicate film) are improved by allowing TiN to have a film density of not less than 5.0 g/cm$^3$, a crystal structure with a (100) orientation, and a film composition (Ti/N) of 1.0 to 1. 2 so that cross reaction between TiN and the high-permittivity gate insulating film can be inhibited.

Prior Art Documents

Patent Documents

Patent Document 1: Japanese Patent Application Laid-Open No. 2001-203276 (FIGS. 1 and 5)
Patent Document 2: Japanese Patent No. 3540613 (FIGS. 1 and 4)
Patent Document 3: Japanese Patent Application Laid-Open No. 2008-16538 (FIGS. 1, 14, and 15)
Patent Document 4: Japanese Patent Application Laid-Open No. 2009-59882

Disclosure of the Invention

Problems to be Solved by the Invention

However, the above techniques have the following problems.

The method described in the Patent Document 1 is an effective technique capable of controlling the work function by the nitrogen concentration of titanium nitride. However, this method uses a silicon nitride film or a silicon oxynitride film as the gate insulating film, therefore does not state the film composition and crystalline orientation of the TiN film suitable for the high-permittivity gate insulating film.

The method of controlling the surface orientation (crystalline orientation of a surface) of the TiN film described in the Patent Document 2 does not state the film composition for obtaining the optimal work function.

Further, the method disclosed in the Patent Document 3 using a laminate of a TiN film formed by CVD and a TiN film formed by PDV is a technique effective at obtaining TiN having a high work function, but has a problem that there is no description about the film density, crystalline orientation, and film composition of the TiN film (second metal layer) in a region in contact with a gate insulating film, by which work function is determined.

Further, the method disclosed in the Patent Document 4 for optimizing the film density, crystal structure (orientation), film composition of a TiN film is effective in that reaction between TiN and a gate insulating film is inhibited, but has a problem that there is no description about the film density, crystal structure (orientation), and film composition of TiN for achieving an optimum work function.

In order to solve the above-mentioned problems associated with the conventional techniques, it is an object of this invention to provide a semiconductor device which includes a high-permittivity insulating film as a gate insulating film and a gate electrode having a metal nitride layer containing Ti and N and which is capable of improving its element characteristics by optimizing the film composition, film density, and crystalline orientation of TiN and a method for manufacturing such a semiconductor device.

Means for Solving the Problems

In order to achieve the above object, this invention provides the following.

A semiconductor device, which comprises a field-effect transistor provided on a silicon substrate and having a gate insulating film and a gate electrode provided on the gate insulating film,
wherein the gate insulating film has a high-permittivity insulating film formed of a metal oxide, a metal silicate, a metal oxide introduced with nitrogen, or a metal silicate introduced with nitrogen,
the gate electrode includes at least a metal nitride layer containing Ti and N,
and at least a part which is in contact with the gate insulating film of the metal nitride layer has a molar ratio between Ti and N (N/Ti ratio) of not less than 1.15 and a film density of not less than 4.7 g/cc.

A method for manufacturing a semiconductor device, which comprises a field-effect transistor provided on a silicon substrate and having a gate insulating film which has a high-permittivity insulating film formed of a metal oxide, a metal silicate, a metal oxide introduced with nitrogen, or a metal silicate introduced with nitrogen and a gate electrode which has a metal nitride layer provided on the gate insulating film and containing Ti and N, the method comprising the step of forming a metal nitride layer having a molar ratio between Ti and N (N/Ti ratio) of not less than 1.15 and a film density of not less than 4.7 g/cc in at least a part which is in contact with a gate insulating film thereof.

Effect of the Invention

According to this invention, it is possible to achieve a work function suitable particularly for a p-type MOSFET without deteriorating the electric characteristics of an element by controlling the film composition, film density, and preferably, crystalline orientation of TiN.

Brief Description of the Drawings

[FIG. 1] A cross-sectional view of an element structure according to an embodiment of this invention.
[FIG. 2] A schematic view of a processing apparatus used in a process of forming a titanium nitride film according to the embodiment of this invention.
[FIG. 3] A view showing a relationship among the film composition, film density, and effective work function of the titanium nitride film according to the embodiment of this invention.
[FIG. 4] A view showing an XRD diffraction spectrum of the titanium nitride film according to the embodiment of this invention.
[FIG. 5] A view showing a relationship between the peak intensity ratio in an XRD spectrum and the film composition of the titanium nitride film according to the embodiment of this invention.
[FIG. 6] A view showing a relationship between EOT and leak current of an element according to the embodiment of this invention.

[FIG. 7] A view showing a relationship between the film composition and the film density of the titanium nitride film according to the embodiment of this invention.

[FIG. 8] A view showing a relationship between the film density and resistivity of the titanium nitride film according to the embodiment of this invention.

[FIG. 9] A cross-sectional view of an element structure according to the embodiment of this invention.

[FIG. 10] A view showing a cross-sectional structure of a semiconductor device according to the Example 1 of this invention.

[FIG. 11] A view showing a relationship between the effective work function and Hf film thickness of the semiconductor device according to the Example 1 of this invention.

[FIG. 12] A view showing processes of a method of manufacturing a semiconductor device according to the Example 2 of this invention.

[FIG. 13] A schematic view of a controller controlling a processing apparatus of FIG. 2.

[FIG. 14] A view showing an internal constitution of the controller of FIG. 13.

Modes for Carrying Out the Invention

Hereinafter, embodiments of this invention will be described in detail based on the drawings.

The present inventors have extensively studied the structure of a titanium nitride film having a high work function in a field-effect transistor element including a high-permittivity gate insulating film and a gate electrode composed of a metal nitride layer containing Ti and N. As a result, the present inventors have newly found a gate electrode that can achieve a high work function, without deteriorating the performance of an element, by using, in at least a part which is in contact with the gate insulating film of its metal nitride layer, a titanium nitride film having a molar ratio between Ti and N (N/Ti ratio) of not less than 1.15 , a film density of not less than 4.7 g/cc , and, preferably, a crystalline orientation X of 1.1<X<1.8.

In this invention, the "crystalline orientation" means a ratio between a (200) peak intensity and a (111) peak intensity (C(200)/C(111)) in an X-ray diffraction spectrum of a metal nitride layer containing Ti and N.

The molar ratio between Ti and N (N/Ti ratio), film density, and, preferably, crystalline orientation X of one metal nitride layer included in the gate electrode may be either uniform or nonuniform in the metal nitride layer as long as they are within their respective ranges mentioned above in at least a part which is in contact with the gate insulating film of the metal nitride layer.

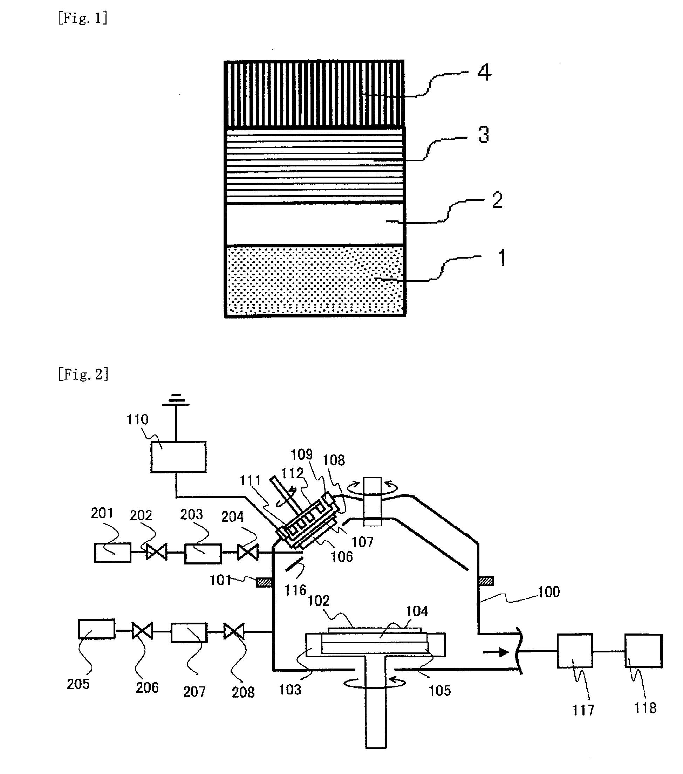

An embodiment of a titanium nitride film in this invention for use in realizing a high work function will be described using, as an example, a MIS (Metal Insulator Semiconductor) capacitor element of FIG. 1. As shown in FIG. 1, a titanium nitride film 3 and a silicon film 4 are formed on a p-type silicon substrate 1 having on its surface a gate insulating film 2 using a silicon oxide film and an HfSiO film as a high-permittivity film.

A high-permittivity material used in the gate insulating film 2 is a material having a relative permittivity larger than the relative permittivity of $SiO_2$ (3.9) and includes a metal oxide, a metal silicate, a metal oxide introduced with nitrogen, and a metal silicate introduced with nitrogen. Preferred is a high-permittivity film introduced with nitrogen in terms of suppressing crystallization and improving the reliability of an element. As a metal in the high-permittivity material, preferred is Hf or Zr in terms of the heat resistance of a film and the suppression of fixed charge in a film. As the high-permittivity material, preferred are a metal oxide containing Hf or Zr and Si and a metal oxynitride which is the metal oxide further containing nitrogen, and more preferred are HfSiO and HfSiON. In this embodiment, although a silicon oxide film and a high-permittivity film stacked on the silicon oxide film are used as the gate insulating film 2, the embodiment is not limited thereto, and a high-permittivity insulating film can be used alone, or silicon oxynitride film and the high-permittivity film stacked on the silicon oxide film can be used.

FIG. 2 schematically shows a processing apparatus used in a process of forming the titanium nitride film 3 in this invention.

A film-formation treatment chamber 100 can be heated to a predetermined temperature by a heater 101. A treated substrate 102 can be heated to a predetermined temperature by a heater 105 through a susceptor 104 incorporated into a substrate support pedestal 103. It is preferable that the substrate support pedestal 103 can be rotated at a predetermined rotation number in terms of uniformity of film thickness. In the film-formation treatment chamber, a target 106 is provided at a position facing the treated substrate 102. The target 106 is provided at a target holder 108 through a back plate 107 formed of metal such as Cu. A form of a target assembly obtained by combining the target 106 and the back plate 107 is formed, as a single component, of a target material, and the form may be attached as a target. Namely, the target may be provided at a target holder. A DC source (DC power supply means) 110 applying power for sputtering discharge is connected to the target holder 108 formed of metal such as Cu, and the target holder 108 is insulated from the wall of the film-formation treatment chamber 100 at a ground potential by an insulator 109. A magnet 111 for use in realizing magnetron-sputtering is provided behind the target 106 as viewed from a sputtering surface. The magnets 111 may be aligned in any manner that generates magnetic flux lines (magnetic flux). The magnets 111 are held by a magnet holder 112 and can be rotated by a magnet holder rotation mechanism (not shown). To uniform erosion of a target, the magnets 111 rotate during discharge. The target 106 is provided at an offset position obliquely upward from the substrate 102.

Namely, a center point of the sputtering surface of the target 106 is located at a position deviating by a predetermined dimension from the normal of the center point of the substrate 102. A shield 116 is provided between the target 106 and the treated substrate 102 to control film formation on the treated substrate 102 by sputtering particles emitted from the target 106 receiving electric power.

The Ti metal target 106 is used as a target. A titanium nitride film is deposited by supplying electric power to the metal target 106 by the DC power supply 110 through the target holder 108 and the back plate 107. At this time, an inert gas from an inert gas source (inert gas introduction means) 201 is introduced from near the target into the film-formation treatment chamber 100 through a valve 202, a mass flow controller 203, and a valve 204. A reactive gas comprising nitrogen is introduced from a nitrogen gas source (reactive gas introduction means) 205 to near the substrate in the film-formation treatment chamber 100 through a valve 206, a mass flow controller 207, and a valve 208. The introduced inert gas and reactive gas are discharged by an exhaust pump 118 through a conductance valve 117.

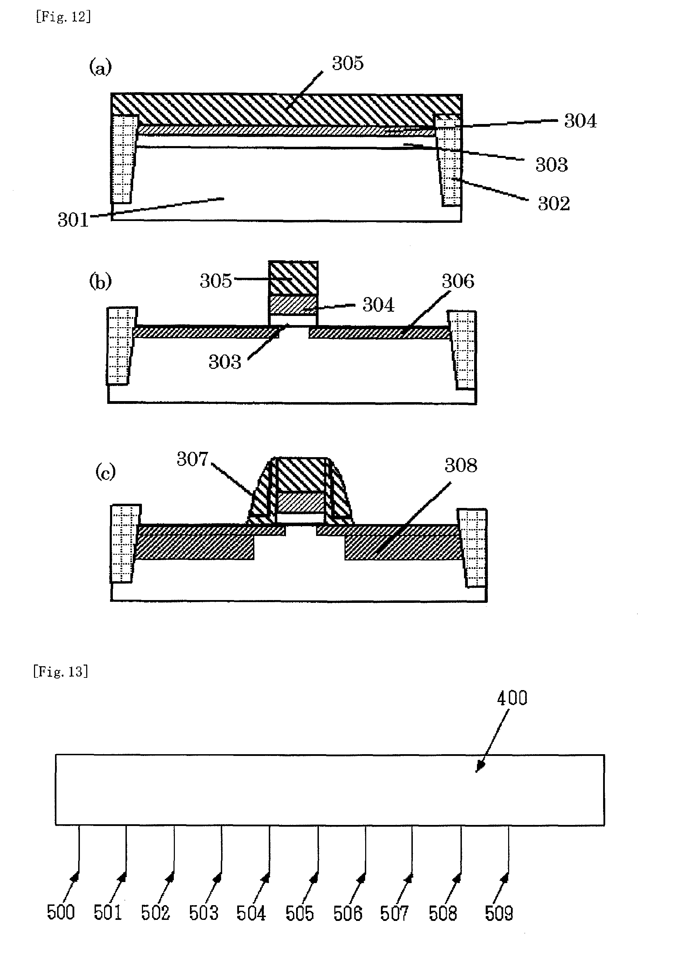

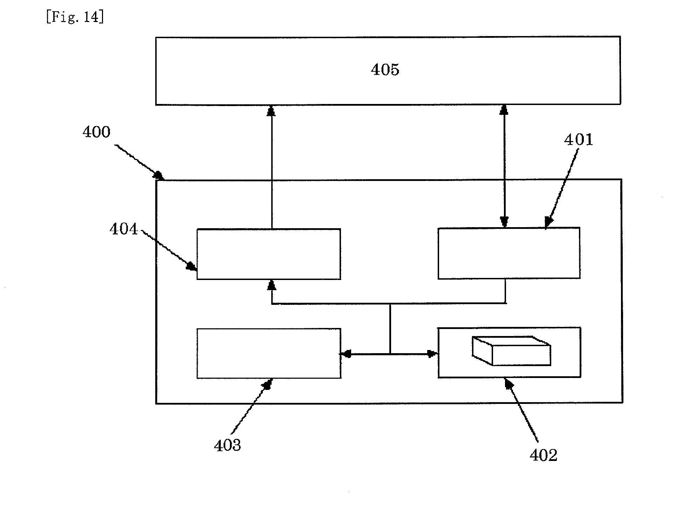

In the deposition of the titanium nitride film 3 in this invention, argon is used as a sputtering gas, and nitrogen is used as a reactive gas. The substrate temperature can be suitably determined within a range of 27°C to 600°C, the target power can be suitably determined within a range of 50W to 1000W, a sputtering gas pressure can be suitably determined within a range of 0.2 Pa to 1.0 Pa, an Ar flow rate can be suitably determined within a range of 0 sccm to 100 sccm (0 Pa·m$^3$/sec to $1.69 \times 10^{-1}$ Pa·m$^3$/sec), and a nitrogen gas flow rate can be suitably determined within a range of 0 sccm to 100 sccm (0 Pa·m$^3$/sec to $1.69 \times 10^{-1}$ Pa·m$^3$/sec). In this embodiment, in the deposition of the titanium nitride film 3, the substrate temperature is set to 30°C, the target power of Ti is set to 750 W, the sputtering gas pressure is set to 0.2 Pa, the argon gas flow rate is changed within a range of 0 sccm to 20 sccm (0 Pa·m$^3$/sec to $3.38 \times 10^{-2}$ Pa·m$^3$/sec), and the nitrogen gas flow rate is changed within a range of 2 sccm to 50 sccm ($3.38 \times 10^{-3}$ Pa·m$^3$/sec to $8.45 \times 10^{-2}$ Pa·m$^3$/sec). The molar ratio between Ti elements and N elements in the titanium nitride film and the crystalline orientation are regulated by the blend ratio between argon and nitrogen introduced in the sputtering, using a controller 400 shown in FIGS. 13 and 14. The "molar ratio" in this specification means a ratio of the number of moles that is the base unit of the amount of material. The molar ratio between the Ti elements and the N elements can be measured from the binding energy of specific electrons in a material and the energy levels and amount of electrons by X-ray photoelectron spectroscopy, for example.

Next, a silicon film 4 of 20 nm is deposited on the deposited titanium nitride film 3 by a sputtering method.

Next, the TiN film is processed to have a desired size using a lithography technique and an RIE (Reactive Ion Etching) technique, and an element is formed.

The composition of the deposited titanium nitride film is analyzed by X-ray photoelectron spectroscopy (XPS). The crystalline orientation of the titanium nitride film is analyzed by an X-ray diffraction (XRD) method. The film density is analyzed by an X-ray reflectivity technique (X-ray Reflect meter). Further, the electric properties including an effective work function, EOT (Equivalent Oxide Thickness, representing an SiO$_2$ equivalent film-thickness), and leak current characteristics are evaluated by C-V, I-V measurement. In this specification, the "effective work function" is generally obtained by a flat band by CV measurement between a gate insulating film and a gate electrode and is influenced by not only the original work function of the gate electrode but also a fixed charge in the insulating film, a dipole formed at the interface, a Fermi level pinning and so on. The effective work function is distinguished from the original "work function" of a material constituting the gate electrode (the energy required for taking an electron from Fermi level to vacuum level). It can be considered that, in the Patent Documents 1 to 4, the "work function" is used in the sense of effective work function because there is a phrase "work function on the insulating film". It is to be noted that in this specification, the effective work function (which will be described later) was determined from a flat band obtained by C-V measurement for a gate insulating film and a gate electrode.

Next, EOT (oxide film equivalent film thickness) will be described. Regardless of the kind of insulating film, it is supposed that an insulating film material is a silicon oxide film, and an electric film thickness of an insulating film obtained by calculating back from the capacity is referred to as the oxide film equivalent film thickness. Namely, when the relative permittivity of the insulating film is sh, the relative permittivity of the silicon oxide film is εo, and the thickness of the insulating film is dh, the oxide film equivalent film thickness de is represented by the following formula (1):

$$\mathrm{de} \ = \ \mathrm{dh} \ \times \ (\varepsilon o / \varepsilon h) \ \ldots \ (1)$$

The formula (1) shows that when a material having a permittivity εh larger than the relative permittivity εo of the silicon oxide film is used in the insulating film, the oxide film equivalent film thickness de is equivalent to the silicon oxide film thinner than the film-thickness dh of the insulating film. The relative permittivity εo of the silicon oxide film is approximately 3.9. Thus, for example, in a film constituted of a high-permittivity material in which sh = 39, even if the physical film thickness dh is 15 nm, the oxide film equivalent film thickness (electric film thickness) de is 1.5 nm, and while the capacity value of the insulating film is kept equal to that of the silicon oxide film with a film-thickness of 1.5 nm, the leak current can be significantly reduced.

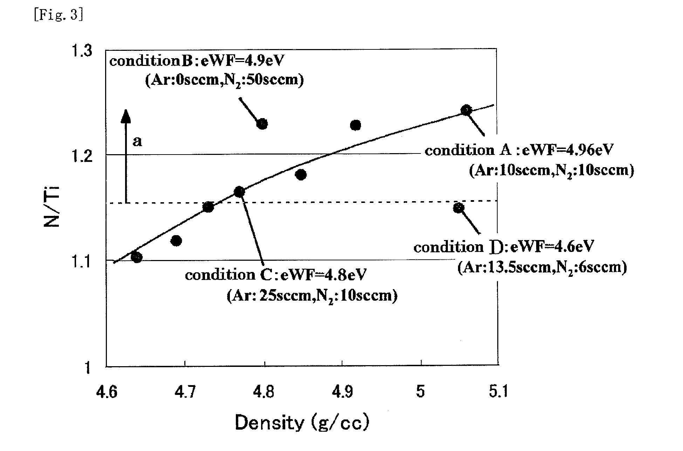

FIG. 3 shows a relationship between the film composition (molar ratio) (N/Ti ratio) and film density of the titanium nitride film according to this invention. A region represented by "a" in FIG. 3 is a region corresponding to a N/Ti ratio for achieving a work function suitable for a p-type MOSFET. Further, in FIG. 3, conditions for forming titanium nitride (flow rates of argon gas and nitrogen gas) and the values of effective work function determined by C-V measurement of major samples are shown. As shown in FIG. 3, a titanium nitride film formed under conditions where the flow rate of argon gas was 10 sccm ($1.69 \times 10^{-2}$ Pa·m$^3$/sec) and the flow rate of nitrogen gas was 10 sccm ($1.69 \times 10^{-2}$ Pa·m$^3$/sec) (hereinafter, referred to as "condition A") had a film composition (molar ratio) of N/Ti= 1.24, a film density of 5.06 g/cc, and an effective work function (eWf) as high as 4.96 eV. Further, a titanium nitride film formed under conditions where the flow rate of argon gas was 0 sccm (0 Pa·m$^3$/sec) and the flow rate of nitrogen gas was 50 sccm ($8.45 \times 10^{-2}$ Pa·m$^3$/sec) (hereinafter, referred to as "condition B") had a film composition (molar ratio) of N/Ti= 1.23, a film density of 4.8 g/cc, and an effective work function (eWF) as high as 4.9 eV. Further, a titanium nitride film formed under conditions where the flow rate of argon gas was 25 sccm ($4.23 \times 10^{-2}$ Pa·m$^3$/sec) and the flow rate of nitrogen gas was 10 sccm ($1.69 \times 10^{-2}$ Pa·m$^3$/sec) (hereinafter, referred to as "condition C") had a film composition (molar ratio) of N/Ti= 1.16, a film density of 4.77 g/cc, and an effective work function (eWF) as high as 4.8 eV. Further, a titanium nitride film formed under conditions where the flow rate of argon gas was 13.5 sccm ($2.28 \times 10^{-2}$ Pa·m$^3$/sec) and the flow rate of nitrogen gas was 6 sccm ($1.01 \times 10^{-2}$ Pa·m$^3$/sec) (hereinafter, referred to as "condition D") had a film composition (molar ratio) of N/Ti= 1.15, a film density of 5.05 g/cc, and an effective work function (eWF) of 4.6 eV, which was lower than those of the films formed under the conditions A to C. As can be seen from FIG. 3, the film composition (molar ratio) (N/Ti ratio), film density, and work function can be controlled by adjusting the flow rate of argon gas and the flow rate of nitrogen gas during sputtering. The work function of a metal has a close relationship with electronegativity, from which it can be considered that the work function increases as the nitrogen content of titanium nitride increases due to the high electronegativity of nitrogen.

Thus, to obtain the work function of not less than 4.6 eV suitable for the P-type MOSFET, the N/Ti ratio is preferably not less than 1.15, and to obtain the work function of not less than 4.9 eV, the N/Ti ratio is preferably not less than 1.2. In the titanium nitride film in this invention, since the effective work function value is increased in accordance with the increase of the film composition (molar ratio) (N/Ti ratio), the titanium nitride film in this invention and the titanium nitride described in the Patent Document 1 (the effective work function is reduced with the increase of the film composition (molar ratio) (N/Ti ratio)) are widely different in the phenomenon.

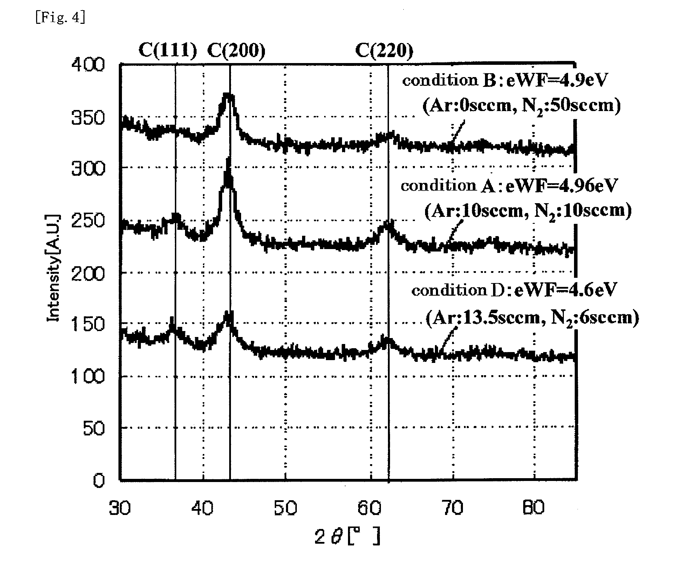

FIG. 4 shows results obtained by comparing XRD diffraction spectrums of the titanium nitride films produced respectively in the conditions A, B, and D. The horizontal axis in FIG. 4 represents a diffraction angle, and the vertical axis represents diffraction intensity. C (111), C(200), and C(220) in FIG. 4 respectively represent a (111) plane, a (200) plane, and a (220) plane which are crystal faces of the titanium nitride film. As shown in FIG. 4, the titanium nitride films in the conditions A and B in which the film composition (molar ratio) (N/Ti ratio) and the effective work function are high have a crystal structure in which the crystalline orientation in the (200) plane is high in comparison with the condition D in which the film composition (molar ratio) (N/Ti ratio) and the effective work function are low.

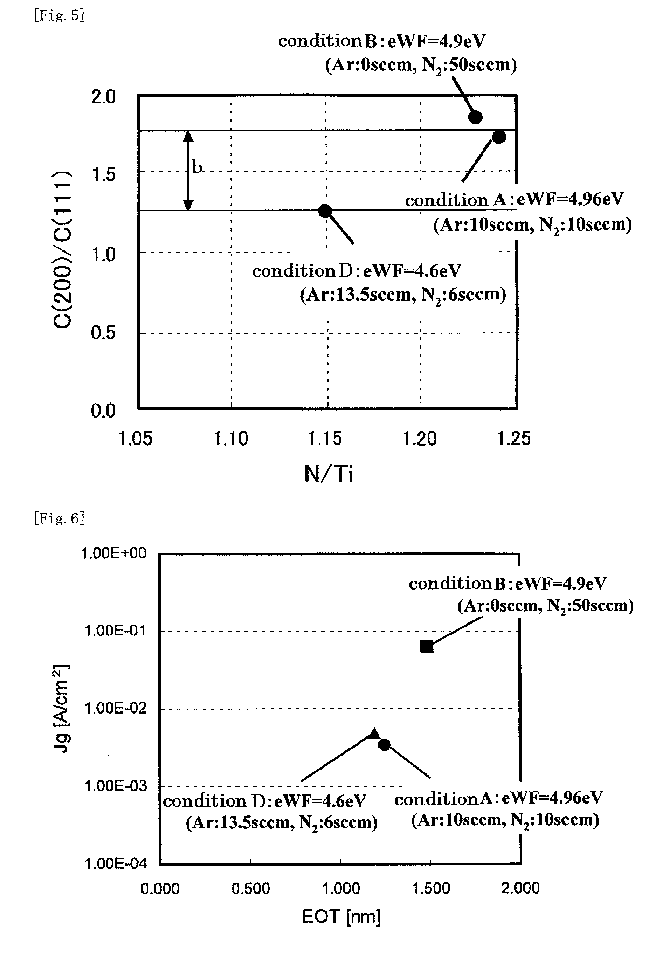

FIG. 5 shows results obtained by comparing the film composition (molar ratio) (N/Ti ratio) of the titanium nitride film with a peak intensity ratio C (200) /C (111) between the (111) plane and the (200) plane in an XRD spectrum (i.e., a result used as an index of crystalline orientation). In FIG. 5, the horizontal axis represents the film composition of the titanium nitride film (molar ratio) (N/Ti ratio), and the vertical axis represents the peak intensity ratio. A region represented by "b" is a region where a work function suitable for a PMOSFET is achieved without deteriorating electric characteristics. As shown in FIG. 5, in the titanium nitride film in which the film compositions (molar ratio) (N/Ti ratio) in the conditions A and B are not less than 1.2, the peak intensity ratio of the titanium nitride film is not less than 1.7 and thus the value is high. Meanwhile, the peak intensity ratio of the titanium nitride film in the condition B is not less than 1.8, and thus the titanium nitride film has a higher value in comparison with the condition A. Thus, in the titanium nitride film having a value of the effective work function of not less than 4.9 eV, the film composition (molar ratio) (N/Ti ratio) is not less than 1.2, and the XRD diffraction spectrum peak intensity ratio C (200) /C(111) as an index of the crystalline orientation is not less than 1. 7. In the titanium nitride film in this invention, even when the titanium nitride film has the crystalline orientation in the (200) plane, the effective work function value is 4.9 eV and thus the value is high. Therefore, it is shown that the titanium nitride film in this invention is different from the titanium nitride film disclosed in the Patent Document 2 where the value of the effective work function is 4.3 eV in the (100) orientation and 4.6 eV in the (111) orientation).

FIG. 6 shows a relationship between EOT (Equivalent Oxide Thickness, representing an SiO$_2$ equivalent film-thickness) and the leak current (Jg) of an element having the titanium nitride films produced in the conditions A, B, and D. As shown in FIG. 6, in comparison with the elements having the titanium nitride films in the conditions A and D, in the element having the titanium nitride film in the condition B, the EOT is increased by 0.2 nm, and the leak current (Jg) is increased by about one digit. This shows that although the titanium nitride film in the condition B has a high work function, the element characteristics may be reduced. The titanium nitride film in the condition B and the titanium nitride films in the conditions A and C are different in that the film density is low, and the peak intensity ratio C(200)/C(111) as an index of the crystalline orientation is not less than 1.8 and thus high. Here, when the electric properties of the element, which has the titanium nitride film having the effective work function value and the peak intensity ratio C(200)/C(111) equivalent to the condition D and having the film density equivalent to the condition B, is evaluated, as a result, it is confirmed that the EOT and the leak current value (Jg) are not deteriorated. Accordingly, it is considered that the EOT and the leak current in the element having the titanium nitride film in the condition B are increased due to the crystalline orientation. As described above, the titanium nitride film according to this invention leads to deterioration of element characteristics when a C (200) crystalline orientation is dominant, and is therefore different from the titanium nitride film disclosed in the Patent Document 4 (which improves element characteristics when having a C (100) orientation). It is to be noted that in a titanium nitride film, a C (200) plane can be regarded as equivalent to a C (100) plane.

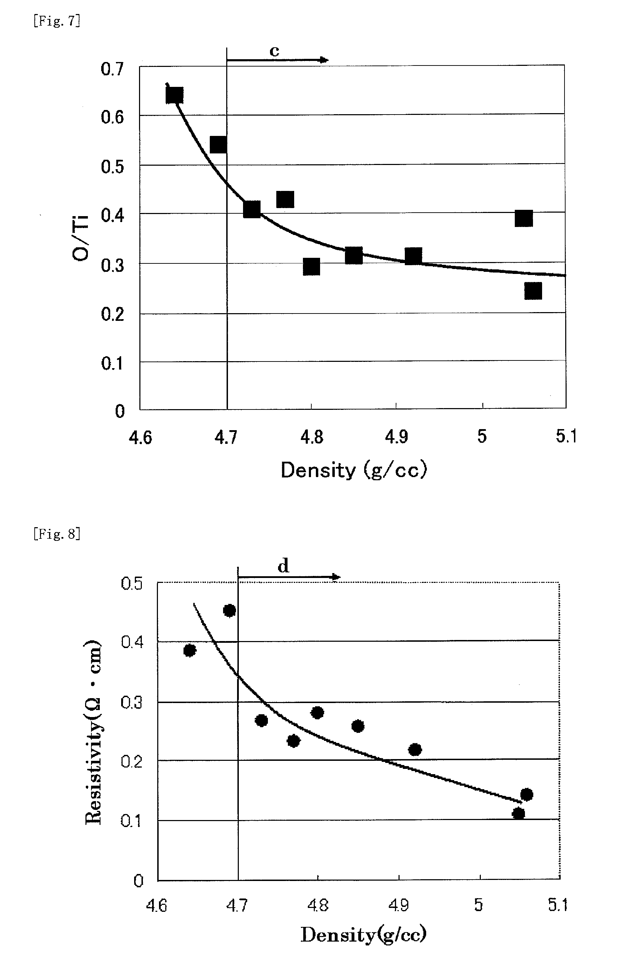

FIG. 7 shows a relationship between the film composition (molar ratio) (O/Ti ratio) and the film density of the titanium nitride film. In FIG. 7, a region indicated by "c" is a region corresponding to a film density for suppressing oxidation of the titanium nitride film. Here, the produced sample is oxidized by being exposed to the air. As shown in FIG. 7, the film composition (molar ratio) (O/Ti ratio) is reduced with the increase of the film density of the titanium nitride film. FIG. 8 shows a relationship between the film density and resistivity of titanium nitride. In FIG. 8, a region indicated by "d" is a region corresponding to a film density for suppressing oxidation of the titanium nitride film and for preventing an increase in resistivity. As can be seen from FIG. 8, the resistivity increases as the film density decreases. An increase in the resistivity of a gate electrode leads to a decrease in the operation speed of a element. Therefore, the film density of the titanium nitride film is preferably not less than 4.7 g/cc , more preferably not less than 4.8 g/cc. The oxidation of the titanium nitride film can be suppressed by depositing a metal containing film such as TaN, W, WN, Si, or Al on the titanium nitride film.

According to the above results, to realize the effective work function suitable for the P-type MSFET, the molar ratio between Ti and N (N/Ti) of the metal nitride layer in this invention is preferably not less than 1.15, and particularly not less than 1.2. Further, to realize the effective work function suitable for the P-type MSFET and to prevent the deterioration of the element electric properties, the peak intensity ratio X of C[200]/C[111] in the XRD spectrum representing the crystalline orientation of the metal nitride layer is preferably within a range of $1.1 < X < 1.8$. Furthermore, to prevent the deterioration of the element characteristics due to oxidation, the film density is preferably not less than 4.7 g/cc, and particularly not less than 4.8 g/cc.

Further, to suppress a change in the gate shape caused by side etching in an etching process of the gate electrode, the film thickness of the metal nitride layer in this invention is preferably not more than 20 nm but not less than 1 nm, and particularly not more than 10 nm but not less than 1 nm.

On the metal nitride layer containing Ti and N according to this invention, preferably on the entire surface of the metal nitride layer, a metal containing film containing at least one selected from TaN, W, WN, Si, and Al is preferably deposited to suppress oxidation due to exposure to the atmosphere.

Furthermore, to suppress the deterioration of the element characteristics due to plasma damage to the gate insulating film and to control the composition and the crystalline orientation, the deposition of the titanium nitride film in this invention is, as shown in FIG. 2, a process of magnetron-sputtering a Ti target under a mixed atmosphere of a reactive gas composed of nitrogen and an inert gas in a film-formation treatment chamber in which a target is provided at an offset position obliquely upward from a substrate. The blend ratio between the reactive gas and the inert gas is preferably set so that the molar ratio between Ti and N in the metal nitride layer is not less than 1.1, and, at the same time, the film density is not less than 4.7 g/cc, and preferably the crystalline orientation X satisfies a range of $1.1 < X < 1.8$.

Furthermore, to improve throughput and suppress the oxidation of the titanium nitride film caused by air exposure, it is preferable to perform the process of forming a metal nitride layer and the process of depositing a metal containing film containing at least one selected from TaN, W, WN, Si, and Ai on the metal nitride layer continuously in a vacuum atmosphere

Furthermore, in the above description, although the element having the gate insulating film using the silicon oxide film and the HfSiO film as a high-permittivity film has been described, this invention is not limited thereto, and the high-permittivity material used in the gate insulating film is a material having a relative permittivity larger than the relative ratio of $SiO_2$ (3.9) and includes a metal oxide, a metal silicate, a metal oxide introduced with nitrogen, and a metal silicate introduced with nitrogen. In terms of the suppression of crystallization and the improvement of the reliability of the element, preferred is a high-permittivity film introduced with nitrogen. As a metal in the high-permittivity material, preferred is Hf or Zr in terms of the heat resistance of a film and the suppression of fixed charge in a film. As the high-permittivity material, preferred are a metal oxide containing Hf or Zr and Si and a metal oxynitride which is the metal oxide further containing nitrogen, and more preferred are HfSiO and HfSiON. In this embodiment, although the silicon oxide film and the high-permittivity film stacked on the silicon oxide film are used as the gate insulating film, this invention is not limited thereto, and a high-permittivity insulating film can be used alone, or silicon oxynitride film and the high-permittivity film stacked on the silicon oxynitride film can be used.

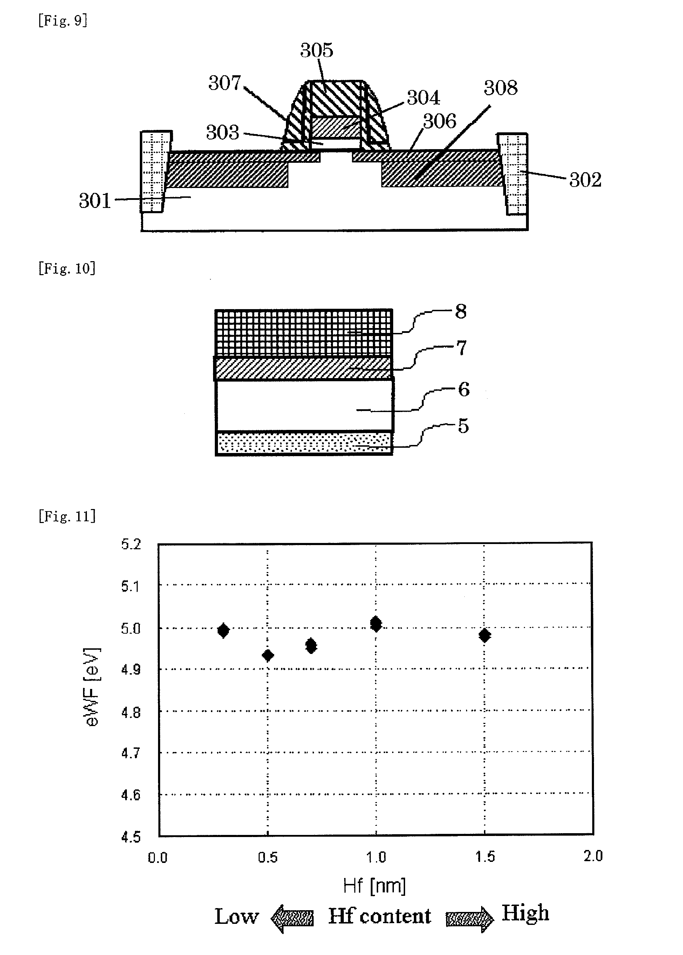

Furthermore, in the above description, although there has been described the element in which the titanium nitride film are formed on the p-type silicon substrate having on its surface the gate insulating film using the silicon oxide film and the HfSiO film as a high-permittivity film, this invention is not limited thereto. Also in the MOSFET element having the gate electrode shown in FIG. 9, if the titanium nitride film satisfying the conditions of this invention is included, the effects can be satisfactorily obtained.

Next, a controller of the processing apparatus of FIG. 2 used in the process of forming the titanium nitride film of the present embodiment will be described. FIG. 13 is a schematic view of a controller controlling the processing apparatus of FIG. 2. Valves 202, 204, 206, and 208 can be controlled to be opened and closed by a controller 400 respectively through control input/output ports 500, 501, 502, and 503. Mass flow controllers 203 and 207 can adjust the flow rate by means of the controller 400 respectively through control input/output ports 504 and 505. In a conductance valve 117, the openness can be adjusted by the controller 400 through a control input/ output port 506. The heater 105 can regulate temperature by means of the controller 400 through a control input/ output port 507. For the rotational state of the substrate support pedestal 103, the number of rotations can be adjusted by the controller 400 through a control input/ output port 508. In the DC power supply 110, the frequency and the supplying power can be adjusted by the controller 400 through an input/output port 509.

In this invention, the blend ratio between an inert gas such as argon gas and a reactive gas composed of nitrogen, which are introduced during sputtering film formation, is controlled by the controller 400 so that at least a part which is in contact with the gate insulating film of the metal nitride layer has a molar ratio between Ti and N (N/Ti ratio) of not less than 1. 15 and a film density of not less than 4.7 g/cc, and preferably, a crystalline orientation X of 1.1<X<1.8.

FIG. 14 is a view showing an internal constitution of the controller 400 of FIG. 13. The controller 400 is constituted of an input part 401, a storage part 402 having programs and data, a processor 403, and an output part 404. The controller 400 basically has a computer configuration and controls the processor 405 of FIG. 2.

A manufacturing program of this invention is recorded in a computer (PC) readable recording medium and installed in the storage part 602 of the controller 600. Examples of the recording medium include a magnetic recording medium such as a floppy (TM) disk and ZIP (TM), a magneto-optical medium such as MO, and an optical disk such as CD-R, DVD-R, DVD+R, DVD-RAM, DVD+RW (TM), and PD. Examples of the recording medium further include a flash memory system such as a Compact Flash (TM), a SmartMedia (TM), a Memory Stick (TM), and an SD card and a removable disk such as a Microdrive (TM) and a Jaz (TM).

The manufacturing program of this invention installed in the storage part 402 is a program for manufacturing a semiconductor device which comprises a field-effect transistor provided on a silicon substrate and having a gate insulating film which has a high-permittivity insulating film formed of a metal oxide, a metal silicate, a metal oxide introduced with nitrogen, or a metal silicate introduced with nitrogen and a gate electrode which has a metal nitride layer provided on the gate insulating film and containing Ti and N.

The program according to this invention causes a computer to execute the procedure of forming a metal nitride layer having a molar ratio between Ti and N (N/Ti ratio) of not less than 1.15 and a film density of not less than 4.7 g/cc in at least a part which is in contact with the gate insulating film thereof.

More specifically, the procedure of forming a metal nitride layer is a procedure of magnetron-sputtering a Ti target under a mixed atmosphere of a reactive gas composed of nitrogen and an inert gas. In this procedure, when at least a part which is in contact with the gate insulating film of a metal nitride layer is formed, the blend ratio between the reactive gas and the inert gas is controlled so that the molar ratio between Ti and N (N/Ti ratio) is not less than 1.15 and the film density is not less than 4.7 g/cc.

As a procedure for forming the gate insulating film, the manufacturing program of this invention may further have a procedure for heating a silicon substrate and depositing a metal film on a treated substrate by physical vapor deposition using a target and a procedure for supplying a gas containing an element oxidizing the metal film and oxidizing the metal film by a thermo-oxidative reaction to form a high-permittivity insulating film.

Examples

<Example 1>

A first example of this invention will be described in detail with reference to the drawings.

FIG. 10 shows a schematic cross-section of an element structure according to the example 1. Hf with a film thickness of 0.3 to 1.5 nm is deposited on a silicon substrate 5, having on its surface a silicon oxide film with a film thickness of 1.8 nm, by a sputtering method. Thereafter, an annealing processing at 900°C for 1 min is applied in an atmosphere with an oxygen partial pressure of 0.1 Pa, and Hf is diffused into the silicon oxide film, whereby a gate insulating film 6 having a stacked structure of the silicon oxide film and an HfSiO film is formed. The Hf concentration in the HfSiO film is changed depending on the film thickness of Hf. Thereafter, in the processing apparatus shown in FIG. 2, a titanium nitride film 7 of 2 nm to 20 nm is deposited on the gate insulating film. In the titanium nitride film 7, the blend ratio between an argon gas flow rate and a nitrogen gas flow rate is regulated using a Ti metal target, whereby the molar ratio between Ti and N is not less than 1.15, and the crystalline orientation X has the range of 1.1 < X < 1.8. Then, a silicon film 8 is deposited on the titanium nitride film 7 to a thickness of 20 nm.

Next, the TiN film is processed to have a desired size using a lithography technique and an RIE (Reactive Ion Etching) technique.

The composition of the deposited titanium nitride film is analyzed by X-ray photoelectron spectroscopy (XPS). The crystalline orientation of the titanium nitride film is analyzed by an X-ray diffraction (XRD) method. The film density is analyzed by an X-ray reflectivity technique (X-ray reflect meter). The electric properties including the effective work function, EOT, and leak current characteristics are evaluated by C-V, I-V measurement.

FIG. 11 shows the dependence of effective work function on Hf film thickness. As can be seen from FIG. 11, the element according to Example 1 having, as a metal nitride layer provided on a gate insulating film, a titanium nitride film having a molar ratio between Ti and N of not less than 1.15 and a crystalline orientation X of 1.1<X<1.8 can achieve an effective work function suitable for a p-type MOSFET (4.6 eV) without depending on the thickness of Hf (Hf concentration). Further, the film density of the metal nitride layer is not less than 4.7 g/cc, and therefore deterioration of electric characteristics of the element associated with an increase in specific resistance due to oxidation is not seen.

Here, the evaluation results of the gate electrode having a stacked structure of a metal nitride layer containing Ti and N and a Si film are shown, but it is confirmed that the same effect can be obtained also by using, as a gate electrode, a single metal nitride layer containing Ti and N or a stacked film comprising a metal nitride film and a metal containing film containing at least one selected from TaN, W, WN, and A1.

Also in an HfSiO film deposited as a gate insulating film by the CVD method, it is confirmed that similar effects are obtained.

After the deposition of HfSiO, even when an HfSiON film formed by a radical nitriding treatment is used as a gate insulating film, it is confirmed that similar effects are obtained.

Even when a material containing Zr as a gate insulating film and selected from a group consisting of ZrSiO, ZrSiON, HfZrSiO, and HfZrSiON is used, it is confirmed that similar effects are obtained.

<Example 2>

A second example of this invention will be described in detail with reference to the drawings.

FIGS. 12(a) to 12(c) are views showing processes of a method of manufacturing a semiconductor device shown in FIG. 9 which is the second example of this invention. First, as shown in FIG. 12 (a), an element isolation region 302 formed by an STI (Shallow Trench Isolation) technique is provided on the surface of a silicon substrate 301. Subsequently, a silicon thermal oxide film with a film thickness of 1.0 nm is formed on the element-isolated silicon substrate surface by a thermal oxidation method. Thereafter, an HfSiO film is deposited by the same method as in the example 1 to form a gate insulating film 303.

Next, a titanium nitride film 304 of 2 nm to 10 nm is deposited on the gate insulating film 303 by the same method as in the example 1. In the titanium nitride film 304, the blend ratio between the argon gas flow rate and the nitrogen gas flow rate is regulated using a Ti metal target, whereby the molar ratio between Ti and N is not less than 1.15, the film density is not less than 4.7 g/cc, and the crystalline orientation X has a range of 1.1 < X < 1.8.

Next, a silicon layer 305 with a film thickness of 20 nm is deposited, and thereafter, as shown in FIG. 12 (b), the silicon layer 306 is processed into a gate electrode using the lithography technique and the RIE technique. Subsequently, ion implantation is performed, and an extension diffusion region 306 is formed in a self-aligned manner by using the gate electrode as a mask.

Further, as shown in FIG. 12(c), a silicon nitride film and a silicon oxide film are sequentially deposited and thereafter etch-backed to thereby form a gate side wall 307. In this state, the ion implantation is performed again, and a source/drain diffusion layer 308 is formed through activation annealing.

As a result of evaluation of the electric properties of the produced element, it is confirmed that the effective work function (not less than 4.6 eV) suitable for the P-type MOSFET can be obtained without deterioration of EOT and leak current.

Further, it is confirmed that the same effect can be obtained also by using a metal containing film containing at least one selected from TaN, W, WN, and Al instead of the silicon film 305.

Also in an HfSiO film deposited as a gate insulating film by the CVD method, it is confirmed that similar effects are obtained.

After the deposition of HfSiO, even when an HfSiON film formed by the radical nitriding treatment is used as a gate insulating film, it is confirmed that similar effects are obtained.

Even when a material containing Zr as a gate insulating film and selected from a group consisting of ZrSiO, ZrSiON, HfZrSiO, and HfZrSiON is used, it is confirmed that similar effects are obtained.

As described above, also in the MOSFET element in this embodiment, it is confirmed that the effects of this invention are obtained.

Description of the Reference Numerals

| | |
|---|---|
| 1 | silicon substrate |
| 2 | gate insulating film |
| 3 | gate electrode |
| 4 | silicon |
| 5 | silicon substrate |
| 6 | gate insulating film |
| 7 | titanium nitride film |
| 8 | silicon film |
| 100 | film-formation treatment chamber |
| 101 | heater |
| 102 | treated substrate |
| 103 | substrate support pedestal |
| 104 | susceptor |
| 105 | heater |
| 106 | metal target |
| 107 | back plate |
| 108 | target holder |
| 109 | insulator |
| 110 | DC source |
| 111 | magnet |
| 112 | magnet holder |
| 116 | shield |
| 117 | conductance valve |
| 118 | exhaust pump |
| 201 | inert gas source |
| 202 | valve |
| 203 | mass flow controller |
| 204 | valve |
| 205 | reactive gas source |
| 206 | valve |
| 207 | mass flow controller |
| 208 | valve |
| 301 | silicon substrate |
| 302 | element isolation region |
| 303 | gate insulating film |
| 304 | metal nitride layer |
| 305 | silicon layer |
| 306 | extension region |
| 307 | gate side wall |
| 308 | source/drain region |

**Claims**

1. A semiconductor device, which comprises a field-effect transistor provided on a silicon substrate and having a gate insulating film and a gate electrode provided on the gate insulating film,
   wherein the gate insulating film has a high-permittivity insulating film formed of a metal oxide, a metal silicate, a metal oxide introduced with nitrogen, or a metal silicate introduced with nitrogen,
   the gate electrode includes at least a metal nitride layer containing Ti and N,
   and at least a part which is in contact with the gate insulating film of the metal nitride layer has a molar ratio between Ti and N (N/Ti ratio) of not less than 1.15 and a film density of not less than 4.7 g/cc.

2. The semiconductor device according to claim 1, wherein the at least a part which is in contact with the gate insulating film of the metal nitride layer has a molar ratio between Ti and N (N/Ti ratio) of not less than 1.2 and a film density of not less than 4.8 g/cc.

3. The semiconductor device according to claim 1 or 2, wherein the at least a part which is in contact with the gate insulating film of the metal nitride layer has a crystalline orientation X of 1.1 < X < 1.8.

4. The semiconductor device according to any one of claims 1 to 3, wherein the gate electrode has a stacked structure comprising the metal nitride layer and a metal containing film containing at least one selected from Al, W, WN, and Si.

5. The semiconductor device according to any one of claims 1 to 4, wherein the metal nitride layer has a film thickness of not more than 20 nm but not less than 1 nm.

6. The semiconductor device according to any one of claims 1 to 5, wherein the high-permittivity insulating film is an insulating film containing Hf or Zr.

7. The semiconductor device according to any one of claims 1 to 6, wherein the gate insulating film has a stacked structure comprising a silicon oxide film or a silicon nitride film and an insulating film containing Hf or Zr.

8. A method for manufacturing a semiconductor device, which comprises a field-effect transistor provided on a silicon substrate and having a gate insulating film which has a high-permittivity insulating film formed of a metal oxide, a metal silicate, a metal oxide introduced with nitrogen, or a metal silicate introduced with nitrogen and a gate electrode which has a metal nitride layer provided on the gate insulating film and containing Ti and N,
   the method comprising the step of forming a metal nitride layer having a molar ratio between Ti and N (N/Ti ratio) of not less than 1.15 and a film density of not less than 4.7 g/cc in at least a part which is in contact with a gate insulating film thereof.

9. The method for manufacturing a semiconductor device according to claim 8, wherein the step of forming a metal nitride layer is a step of forming a metal nitride layer having a crystalline orientation X of 1.1 <X< 1.8 in at least a part which is in contact with the gate insulating film thereof.

10. The method for manufacturing a semiconductor device according to claim 8 or 9, further comprising the step of forming a metal containing film containing at least one selected from Al, W, WN, and Si on an entire surface of the metal nitride layer without exposure to the atmosphere.

11. The method for manufacturing a semiconductor device according to any one of claims 8 to 10, wherein the step of forming a metal nitride layer is a step of magnetron-sputtering a Ti target under a mixed atmosphere of a reactive gas composed of nitrogen and an inert gas, and wherein when at least a part which is in contact with the gate insulating film of the metal nitride layer is formed, the blend ratio between the reactive gas and the inert gas is set so that the molar ratio between Ti and N (N/Ti ratio) is not less than 1.15 and the film density is not less than 4.7 g/cc.

12. The method for manufacturing a semiconductor device according to claim 11, wherein when at least a part which is in contact with the gate insulating film of the metal nitride layer is formed, a blend ratio between the reactive gas and the inert gas is set so that the crystalline orientation X satisfies the range of $1.1 < X < 1.8$.

13. An apparatus for manufacturing a semiconductor device, which comprises a field-effect transistor provided on a silicon substrate and having a gate insulating film, having a high-permittivity insulating film formed of a metal oxide, a metal silicate, a metal oxide introduced with nitrogen, or a metal silicate introduced with nitrogen, and a gate electrode provided on the gate insulating film and having a metal nitride layer containing Ti and N, the apparatus comprising:

> a film-formation treatment chamber; a substrate support pedestal configured and positioned to support a treated substrate; a heating device configured and positioned to control a temperature of the substrate support pedestal; an inert gas introduction means configured and positioned to introduce an inert gas into the film-formation treatment chamber; a reactive gas introduction means configured and positioned to introduce a reactive gas composed of nitrogen into the film-formation treatment chamber; a DC power supply means configured and positioned to supply DC power to a target; and a controller configured and positioned to adjust a blend ratio between an inert gas and a reactive gas introduced into the film-formation treatment chamber so that at least a part which is in contact with the gate insulating film of the metal nitride layer has a molar ratio between Ti and N (N/Ti ratio) of not less than 1.15 and a film density of not less than 4.7 g/cc .

14. A program for manufacturing a semiconductor device, which comprises a field-effect transistor provided on a silicon substrate and having a gate insulating film which has a high-permittivity insulating film formed of a metal oxide, a metal silicate, a metal oxide introduced with nitrogen, or a metal silicate introduced with nitrogen and a gate electrode which has a metal nitride layer provided on the gate insulating film and containing Ti and N, wherein the program causing a computer to execute a procedure for forming a metal nitride layer having a molar ratio between Ti and N (N/Ti ratio) of not less than 1.15 and a film density of not less than 4.7 g/cc in at least a part which is in contact with a gate insulating film thereof.

15. The program for manufacturing a semiconductor device according to claim 14, wherein the procedure of forming a metal nitride layer is a procedure of magnetron-sputtering a Ti target under a mixed atmosphere of a reactive gas composed of nitrogen and an inert gas, and wherein when at least a part which is in contact with the gate insulating film of the metal nitride layer is formed, the blend ratio between the reactive gas and the inert gas is controlled so that the molar ratio between Ti and N (N/Ti ratio) is not less than 1.15 and the film density is not less than 4.7 g/cc.

16. A computer-readable recording medium having the manufacturing program according to claim 14 or 15 is recorded.

[Fig. 1]

[Fig. 2]

[Fig. 3]

[Fig. 4]

[Fig. 5]

[Fig. 6]

[Fig. 7]

[Fig. 8]

[Fig. 9]

[Fig. 10]

[Fig. 11]

[Fig. 12]

(a)

305

304

303

302

301

(b)

305

304

306

303

(c)

307

308

[Fig. 13]

400

500 501 502 503 504 505 506 507 508 509

[Fig. 14]

<table>
<tr><td colspan="3">**INTERNATIONAL SEARCH REPORT**</td><td>International application No.<br>PCT/JP2010/004803</td></tr>
</table>

**A. CLASSIFICATION OF SUBJECT MATTER**
*H01L21/336*(2006.01)i, *C23C14/06*(2006.01)i, *H01L21/28*(2006.01)i,
*H01L21/285*(2006.01)i, *H01L29/423*(2006.01)i, *H01L29/49*(2006.01)i,
*H01L29/78*(2006.01)i
According to International Patent Classification (IPC) or to both national classification and IPC

**B. FIELDS SEARCHED**

Minimum documentation searched (classification system followed by classification symbols)
H01L21/336, C23C14/06, H01L21/28, H01L21/285, H01L29/423, H01L29/49,
H01L29/78

Documentation searched other than minimum documentation to the extent that such documents are included in the fields searched
Jitsuyo Shinan Koho       1922–1996   Jitsuyo Shinan Toroku Koho   1996–2010
Kokai Jitsuyo Shinan Koho   1971–2010   Toroku Jitsuyo Shinan Koho   1994–2010

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | Yongxun Liu et al., Investigation of the TiN Gate Electrode With Tunable Work Function and Its Applications for FinFET Fabrication, IEEE TRANSACTIONS ON NANOTECHNOLOGY, 2006, VOL.5, NO.6, PP.723-730 | 1-16 |
| A | Jörgen Westlinder et al., Variable work function in MOS capacitors utilizing nitrogen-controlled TiNx gate electrodes, Microelectronic Engineering, 2004, Vol.75, pp.389-396 | 1-16 |
| A | G.Sjoblom et al., Investigation of the Thermal Stability of Reactively Sputter-Deposited TiN MOS Gate Electrodes, IEEE TRANSACTIONS ON ELECTRON DEVICES, 2005, VOL.52, NO.10, PP.2349-2352 | 1-16 |

[X] Further documents are listed in the continuation of Box C.        [ ] See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>26 October, 2010 (26.10.10) | Date of mailing of the international search report<br>09 November, 2010 (09.11.10) |
|---|---|
| Name and mailing address of the ISA/<br>Japanese Patent Office | Authorized officer |
| Facsimile No. | Telephone No. |

Form PCT/ISA/210 (second sheet) (July 2009)

20

**INTERNATIONAL SEARCH REPORT**

| International application No. |
| --- |
| PCT/JP2010/004803 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2009-59882 A  (NEC Electronics Corp.),<br>19 March 2009 (19.03.2009),<br>paragraphs [0015] to [0016]<br>& US 2009/0057787 A1     & CN 101378077 A | 1-16 |
| A | JP 2001-203276 A  (NEC Corp.),<br>27 July 2001 (27.07.2001),<br>paragraph [0065]; fig. 5<br>& US 2001/0015463 A1     & US 6916695 B2<br>& KR 10-2001-0076304 A | 1-16 |
| P,A | JP 2010-118443 A  (Panasonic Corp.),<br>27 May 2010 (27.05.2010),<br>paragraphs [0027] to [0031]; fig. 1 to 3<br>& WO 2010/055603 A1 | 1-16 |
| A | JP 11-224947 A  (Toshiba Corp.),<br>17 August 1999 (17.08.1999),<br>paragraphs [0141], [0145]<br>& US 6271573 B1 | 1-16 |
| A | JP 9-41133 A  (Sony Corp.),<br>10 February 1997 (10.02.1997),<br>paragraphs [0013] to [0014]; fig. 5, 6, 8, 9<br>(Family: none) | 1-16 |
| A | JP 8-250452 A  (Fujitsu Ltd.),<br>27 September 1996 (27.09.1996),<br>paragraphs [0017] to [0019]<br>(Family: none) | 1-16 |
| A | JP 10-125627 A  (Fujitsu Ltd.),<br>15 May 1998 (15.05.1998),<br>paragraph [0007]<br>& US 6242804 B1 | 1-16 |
| A | JP 10-284498 A  (Denso Corp.),<br>23 October 1998 (23.10.1998),<br>paragraph [0031]; fig. 12<br>(Family: none) | 1-16 |

Form PCT/ISA/210 (continuation of second sheet) (July 2009)

**EP 2 461 354 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001203276 A
- JP 3540613 B
- JP 2008016538 A
- JP 2009059882 A